# EUROPEAN PATENT APPLICATION

(11) **EP 3 869 272 A1**
(43) Date of publication of application: **25.08.2021**
(21) Application number: 20158702.9
(22) Date of filing: 21.02.2020
(51) Int. Cl.: G03F 7/20, H01L 21/687

(54) **SUBSTRATE TABLE AND METHOD OF HANDLING A SUBSTRATE**

(71) Applicant: ASML Netherlands B.V., 5500 AH Veldhoven (NL)
(72) Inventor: TEN KATE, Nicolaas, 5500 AH Veldhoven (NL); WINKELS, Koen, Gerhardus, 5500 AH Veldhoven (NL); HABETS, Michel, Ben, Isel, 5500 AH Veldhoven (NL)
(74) Representative: ASML Netherlands B.V.

(57) **Abstract**

The disclosure relates to substrate tables for lithography and methods of handling a substrate. In one arrangement, a substrate table comprises one or more membranes. An actuation system deforms each membrane to change a height of a portion of the membrane. In another arrangement, a substrate table comprises one or more membranes and a clamping system for clamping a substrate to the substrate table, wherein the clamping deforms each membrane by pressing the substrate against the membrane.

## Description

### FIELD

The present invention relates to a substrate table for supporting a substrate during a lithography process, and to methods of handling a substrate.

### BACKGROUND

A lithographic apparatus is a machine constructed to apply a desired pattern onto a substrate in a lithography process. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as "Moore's law". To keep up with Moore's law the semiconductor industry is seeking technologies that make it possible to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

A lithographic apparatus may include an illumination system for providing a projection beam of radiation, and a support structure for supporting a patterning device. The patterning device may serve to impart the projection beam with a pattern in its cross-section. The apparatus may also include a projection system for projecting the patterned beam onto a target portion of a substrate.

In a lithographic apparatus the substrate to be exposed (which may be referred to as a production substrate) may be held on a substrate table (sometimes referred to as a wafer table or substrate holder). The substrate table may be moveable with respect to the projection system. A substrate-facing surface of the substrate table may be provided with a plurality of projections (referred to as burls). The distal surfaces of the burls may conform to a flat plane and support the substrate. The burls can provide several advantages: a contaminant particle on the substrate table or on the substrate is likely to fall between burls and therefore does not cause a deformation of the substrate; it is easier to machine the burls so their ends conform to a plane than to make the surface of the substrate table flat; and the properties of the burls can be adjusted, e.g. to control clamping of the substrate to the substrate table.

Production substrates may become distorted due to frictional forces between the burls and the substrate. It is desirable to reduce these frictional forces.

### SUMMARY

An object of the present invention is to improve handling of substrates for lithography.

According to an aspect of the invention, there is provided a substrate table configured to support a substrate during a lithography process, comprising: one or more membranes; and an actuation system configured to deform each membrane to change a height of a portion of the membrane.

According to an aspect of the invention, there is provided a substrate table configured to support a substrate during a lithography process, comprising: one or more membranes, each membrane being deformable to change a height of a portion of the membrane; and a clamping system for clamping a substrate to the substrate table, wherein the clamping deforms each membrane by pressing the substrate against the membrane.

According to a further aspect, there is provided a method of handling a substrate, comprising: loading the substrate onto a substrate table comprising one or more membranes; and deforming each of one or more of the membranes to change a height of a portion of the membrane during or after the loading of the substrate.

Further embodiments, features and advantages of the present invention are described in detail below with reference to the accompanying drawings.

### BRIEF DESCRIPTION OF THE DRAWINGS

Embodiments of the invention will now be described by way of example only, with reference to the accompanying schematic drawings in which corresponding reference symbols indicate corresponding parts, and in which:
Figure 1 schematically depicts an overview of a lithographic apparatus;
Figure 2 schematically depicts a substrate table comprising burls and an actuation system;
Figure 3 is a schematic side sectional view depicting a burl comprising a membrane hydraulically or pneumatically actuated into a low state;
Figure 4 is a schematic side sectional view depicting the burl of Figure 3 with the membrane in an unactuated state;
Figure 5 is a schematic side sectional view depicting the burl of Figure 3 with the membrane hydraulically or pneumatically actuated into a high state;
Figure 6 is a schematic side sectional view depicting a burl comprising a membrane mechanically actuated into a low state;
Figure 7 is a schematic side sectional view depicting the burl of Figure 6 with the membrane in an unactuated state;
Figure 8 is a schematic side sectional view depicting the burl of Figure 6 with the membrane mechanically actuated into a high state;
Figure 9 is a schematic side sectional view depicting a membrane positioned between burls and hydraulically or pneumatically actuated into a low state;
Figure 10 is a schematic side sectional view depicting the membrane of Figure 9 in an unactuated state;
Figure 11 is a schematic side sectional view depicting the membrane of Figure 9 hydraulically or pneumatically unactuated into a high state;
Figure 12 is a schematic side sectional view depicting a burl comprising a rigid contacting member hydraulically or pneumatically actuated into a low state by actuation of a membrane;
Figure 13 is a schematic side sectional view depicting the burl of Figure 12 with the rigid contacting member at an intermediate position corresponding to the membrane being in an unactuated state;
Figure 14 is a schematic side sectional view depicting the burl of Figure 12 with the rigid contacting member hydraulically or pneumatically actuated into a high state by actuation of the membrane;
Figure 15 is a schematic side sectional view depicting a rigid contacting member positioned between burls and hydraulically or pneumatically actuated into a low state by actuation of a membrane;
Figure 16 is a schematic side sectional view depicting the rigid contacting member of Figure 15 at an intermediate position corresponding to the membrane being in an unactuated state;
Figure 17 is a schematic side sectional view depicting the rigid contacting member of Figure 15 hydraulically or pneumatically actuated into a high state by actuation of the membrane;
Figure 18 is a schematic side sectional view of the arrangement of Figure 13 with the addition of a rigid abutment member beneath the membrane;
Figure 19 is a schematic side sectional view of the arrangement of Figure 18 with the rigid contacting member hydraulically or pneumatically actuated into a high state by actuation of the membrane;
Figure 20 is a schematic side sectional view of the arrangement of Figure 16 with the addition of rigid abutment member beneath the membrane;
Figure 21 is a schematic side sectional view of the arrangement of Figure 20 with the rigid contacting member hydraulically or pneumatically actuated into a high state by actuation of the membrane;
Figure 22 is a schematic side sectional view of an arrangement in which rigid burls are replaced by rigid contacting members that can be moved up and down by actuating membranes beneath the rigid contacting members, with rigid abutment members also being provided beneath the membranes;
Figure 23 is a schematic top view of a burl comprising a hydraulically or pneumatically actuatable membrane having a shape when viewed from above that forms a hollow closed loop;
Figure 24 is a schematic side sectional view of the burl of Figure 23 with the membrane in an unactuated state;
Figure 25 is a schematic side sectional view of the burl of Figure 23 with the membrane hydraulically or pneumatically actuated into a high state;
Figure 26 is a schematic side sectional view of a dome-shaped burl comprising a hydraulically or pneumatically actuatable membrane of the type depicted in Figures 23-25 in an unactuated state;
Figure 27 is a schematic side sectional view of the burl of Figure 26 with the membrane hydraulically or pneumatically actuated into a high state;
Figure 28 is a schematic top view of an actuation system configured to simultaneously actuate membranes positioned on plural adjacent rings;
Figure 29 is a schematic side sectional view along the broken line in Figure 28;
Figure 30 is a schematic top view of an actuation system configured to simultaneously actuate membranes positioned on rings that are interleaved by rings comprising fixed burls that are not actuated;
Figure 31 is a schematic side sectional view along the broken line in Figure 30;
Figure 32 is a schematic top view of an actuation system configured to selectively actuate different groups of membranes;
Figure 33 is a schematic side sectional view along the broken line in Figure 32; and
Figure 34 is a schematic side sectional view of a membrane having plural layers.

The features shown in the figures are not necessarily to scale, and the size and/or arrangement depicted is not limiting. It will be understood that the figures include optional features which may not be essential to the invention.

### DETAILED DESCRIPTION

In the present document, the terms "radiation" and "beam" are used to encompass all types of electromagnetic radiation, including ultraviolet radiation (e.g. with a wavelength of 436, 405, 365, 248, 193, 157, 126 or 13.5 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

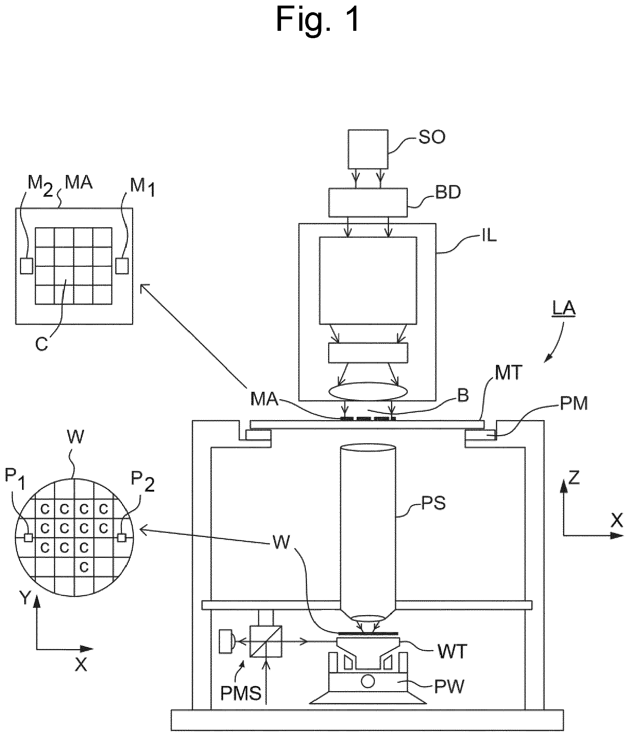

Figure 1 schematically depicts a lithographic apparatus LA. The lithographic apparatus includes an illumination system (also referred to as illuminator) IL configured to condition a radiation beam B (e.g., EUV radiation or DUV radiation), a mask support (e.g., a mask table) MT constructed to support a patterning device (e.g., a mask) MA and connected to a first positioner PM configured to accurately position the patterning device MA in accordance with certain parameters, a substrate table WT constructed to hold a substrate (e.g., a resist coated wafer) W and connected to a second positioner PW configured to accurately position the substrate table WT in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives the radiation beam B from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate W may be covered by an immersion liquid having a relatively high refractive index, e.g., water, so as to fill an immersion space between the projection system PS and the substrate W - which is also referred to as immersion lithography. More information on immersion techniques is given in US 6,952,253, which is incorporated herein by reference.

The lithographic apparatus may be of a type having two or more substrate tables WT (also named "dual stage"). In such "multiple stage" machine, the substrate tables WT may be used in parallel, and/or steps in preparation of a subsequent exposure of the substrate W may be carried out on the substrate W located on one of the substrate table WT while another substrate W on the other substrate table WT is being used for exposing a pattern on the other substrate W.

In addition to the substrate table WT, the lithographic apparatus may comprise a measurement stage (not depicted in Fig. 1). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate table WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system PMS, the substrate table WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

In this specification, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

In a lithographic apparatus it is necessary to position with great accuracy the upper surface of a substrate to be exposed in the plane of best focus of the aerial image of the pattern projected by the projection system. To achieve this, the substrate can be held on a substrate table. The surface of the substrate table that supports the substrate can be provided with a plurality of burls whose distal ends can be coplanar in a nominal support plane. The burls, though numerous, may be small in cross-sectional area parallel to the support plane so that the total cross-sectional area of their distal ends is a few percent, e.g. less than 5%, of the surface area of the substrate. The gas pressure in the space between the substrate table and the substrate may be reduced relative to the pressure above the substrate to create a force clamping the substrate to the substrate table. Alternatively or additionally, an electrostatic clamping force may be used to clamp the substrate to the substrate table.

When a substrate is loaded onto a substrate table, the substrate generally does not land perfectly flat on the substrate table. This means that during loading of a substrate, one point of the substrate tends to make contact with at least one of the burls and then the rest of the substrate comes into contact with the substrate table. Frictional forces between the substrate and the substrate table during loading may lead to in-plane deformation in the substrate as the substrate makes contact across the substrate table. Similar effects may occur during unloading. The in-plane deformation can increase overlay errors.

Embodiments described below address this issue by using actuatable membranes in the substrate table WT to control how contacts are made between the substrate table WT and the substrate W. The control may be applied at various points during manipulation of the substrate W by the substrate table WT. The control may reduce frictional forces and/or relieve stresses caused by frictional forces.

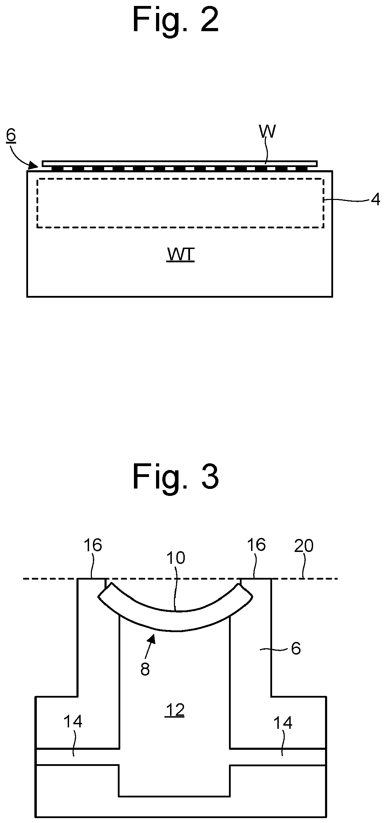

Figure 2 depicts a substrate table WT suitable for supporting a substrate W during a lithography process. Rigid burls 6 are provided on an upper surface of the substrate table WT. The burls 6 make contact with the substrate W and support the substrate W. The burls 6 may comprise a plurality of protrusions from an otherwise substantially planar upper surface of the substrate table WT. Upper tips of the burls 6 may be arranged to be substantially co-planar. The upper tips of the burls 6 may simultaneously contact the substrate W in the nominal case where the substrate W is perfectly planar. The substrate table WT may comprise a clamping mechanism for holding the substrate W against the burls 6 during the lithography process (e.g. while the substrate table WT is scanned during exposure of the substrate W by a lithographic apparatus LA as described above).

In various embodiments, as will be exemplified below with reference to Figures 3 onwards, the substrate table WT further comprises one or more membranes 8. The substrate table WT further comprises an actuation system 4 (referring to Figure 2). The actuation system 4 is capable of deforming each membrane 8. The deformation of the membrane 8 changes a height of a portion 10 of the membrane 8. The change in height of the portion 10 of the membrane 8 can be used in various ways to change how contact is made with the substrate W. Providing the ability to change how contact is made increases flexibility in comparison with alternative approaches that exclusively use rigid burls to contact the substrate W. The improved flexibility makes it easier to achieve low friction contact between the substrate W and the substrate table WT during loading (to reduce friction-induced internal stresses in the substrate W) and high friction contact during exposure in a lithography process. The lifetime of substrate table WT may also be improved, either by distributing contact between a larger number of different elements and/or providing flexibility to improve the mechanical and/or chemical wear resistance of at least some of the elements of the substrate table WT that contact the substrate W.

Deformation of a membrane 8 caused by the actuation system 4 may be referred to as actuation of the membrane 8. In the examples given below, a planar configuration of the membrane 8 is described as an unactuated state of the membrane 8. It will be appreciated, however, that each of one or more of the membranes 8 could be manufactured in such a way that the unactuated state of the membrane 8 is not a planar configuration. For example, each of one or more of the membranes 8 could be manufactured to be convex (protruding upwards) or concave (protruding downwards) in the unactuated state. This could be achieved, for example, by pre-stressing or otherwise shaping the membrane 8 into the form that is desired for the unactuated state.

The term membrane is understood herein to cover any arrangement of material that is thin enough to be deformable by the actuation system 4 in the context of a substrate table WT for supporting a substrate W during a lithography process.

In some embodiments, each membrane 8 is configured such that, when the substrate W is supported by the substrate table WT, the changing of height of the portion 10 of the membrane 8 causes a change in a spatial distribution of forces applied between the substrate table WT and the substrate W. For example, each membrane 8 may be configured such that, when the substrate W is supported by the substrate table WT, the changing of height of the portion 10 of the membrane 8 causes a contact element to move from a position out of contact with the substrate W to a position in contact with the substrate W. Alternatively, the changing of height of the portion 10 of the membrane 8 may cause a contact element to move from a position in contact with the substrate W to a position out of contact with the substrate W. Each membrane 8 may therefore be used to control whether a corresponding contact member is in contact with the substrate W.

Figures 3-5 depicts a single rigid burl 6 in an example embodiment in which the substrate table WT comprises a plurality of the rigid burls 6. The burls 6 are configured to contact the substrate W. Each burl 6 comprises a distal tip 16. In the example shown, the burl 6 may be substantially cylindrical in form. An axis of the cylinder is perpendicular to the substrate W. In this example, the distal tip 16 forms an annulus surrounding the membrane 8 when viewed from above. In an embodiment, the distal tips 16 of two or more of the burls 6 are in the same plane 20 (depicted by the broken line in the figures). A nominally planar substrate W can be simultaneously in contact with, and thereby supported by, the two or more burls 6. In some embodiments with a plurality of burls 6, as exemplified in Figures 3-5, each of one or more of the membranes 8 is formed within a respective one of the burls 6. Actuation of the membranes 8 can be used to switch between a situation where distal tips 16 of the rigid burls 6 contact the substrate W and a situation where the membranes 8 in the burls 6 contact the substrate W. Actuation of the membranes 8 thus changes how contact is made between the substrate table WT and the substrate W.

In some embodiments, the actuation system 4 is configured to deform each of one or more of the membranes 8 by changing a pressure of a fluid in contact with the membrane 8. The fluid may be provided in a chamber 12 beneath the membrane 8. In embodiments where the fluid is a liquid, the actuation may be referred to as hydraulic actuation. In embodiments where the fluid is a gas, the actuation may be referred to as pneumatic actuation. In the example of Figures 3-5, the fluid may be brought to the chamber 12 beneath each membrane 8 by fluid distribution channels 14 leading to the chamber 12. Controlling a pressure in the fluid distribution channels 14 controls a pressure in the chamber 12. The actuation system 4 in such embodiments may therefore comprise any suitable combination of fluid handling elements (e.g. pumps, valves, conduits, etc.), as wells as chambers 12 and fluid distribution channels 14, suitable for achieving this functionality.

Figure 3 depicts a situation where the pressure in chamber 12 of the burl 6 depicted is lower than a pressure above the membrane 8. The pressure difference across the membrane 8 pushes the membrane 8 downwards, causing the membrane 8 to deform. Portion 10 of the membrane 8 is moved downwards by the deformation. All of the membrane 8 is below the plane 20 of the distal tips 16 of the burls 6 so there is no direct contact between the membrane 8 and the substrate W. The deformation of the membrane 8 may, however, apply a force to the substrate W by increasing the volume of the space between the substrate table WT and the substrate W and thereby reducing the pressure in this volume (effectively applying a sucking action).

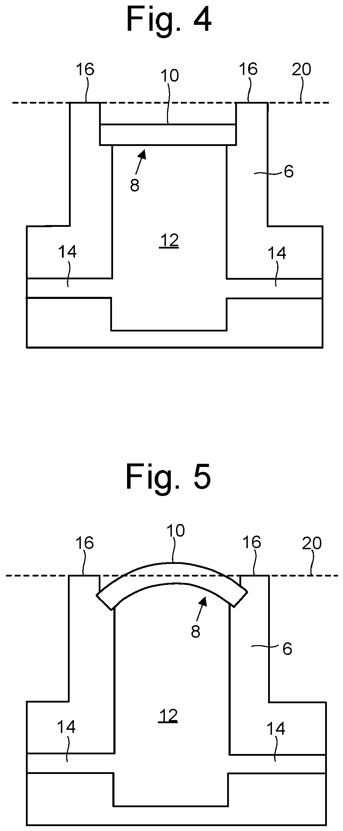

Figure 4 depicts the burl 6 of Figure 3 when the pressure in chamber 12 of the burl 6 is close to or equal to the pressure above the membrane 8. The membrane 8 is substantially undeformed in this state. An uppermost portion 10 of the membrane 8 is below the plane 20 of the distal tips 16 of the burls 6 so there is no direct contact between the membrane 8 and the substrate W. In contrast to the situation in Figure 3, no sucking action is applied by the membrane 8. Figure 4 depicts an example of the membrane 8 in an unactuated state.

Figure 5 depicts the burl 6 of Figures 3 and 4 when the pressure in chamber 12 of the burl 6 is higher than the pressure above the membrane 8. The pressure difference across the membrane 8 pushes the membrane 8 upwards, causing the membrane 8 to deform. Portion 10 of the membrane 8 is moved upwards by the deformation to a height that is above the plane 20 of the distal tips 16 of the burls 6. Direct contact can therefore occur between the portion 10 of the membrane 8 and the substrate W.

The actuation system 4 can selectively switch the membrane 8 between the states depicted in Figures 3-5 to control whether contact is made between the membrane 8 of the burl 6 and the substrate W or between the distal tip 16 of the burl 6 and the substrate W. A surface of the membrane 8 may be configured such that a contact between the membrane 8 and the substrate W has different mechanical properties than contact between the burl 6 and the substrate W. For example, in comparison with a respective burl 6, a surface of a membrane 8 contacting the substrate W may be configured to have a different composition (with corresponding different coefficient of friction, for example), a different coating, a different roughness, a different stiffness, and/or a different contact area. Arranging for the membrane 8 to provide a lower friction and/or lower horizontal stiffness contact with the substrate W may be desirable during loading of the substrate W onto the substrate WT to reduce friction-induced stresses in the substrate W (the lower friction allows more slippage and the lower horizontal stiffness allows the contact itself to shift to accommodate stresses).

In some embodiments, the actuation system 4 comprises a clamping system for clamping a substrate W to the substrate table WT. The clamping may be achieved by applying vacuum to a region behind the substrate W or by electrostatic clamping. The clamping may deform each membrane 8 by causing the substrate W to press against the membrane 8. The membranes 8 may thus be arranged to be the highest points of the substrate table WT during a portion of a loading process of the substrate W onto the substrate table WT. For example, where the substrate table WT comprises a plurality of rigid burls 6, a portion of each membrane 8 may be arranged to be higher than the rigid burls 6, as depicted in Figure 5 for example, when the membrane 8 is in an undeformed state. The arrangement allows the membranes 8 to contact the substrate W first during clamping, thereby allowing friction-induced internal stresses in the substrate W to be reduced without necessarily having any separate actuation mechanism for actuating the membranes 8 (apart from the clamping system).

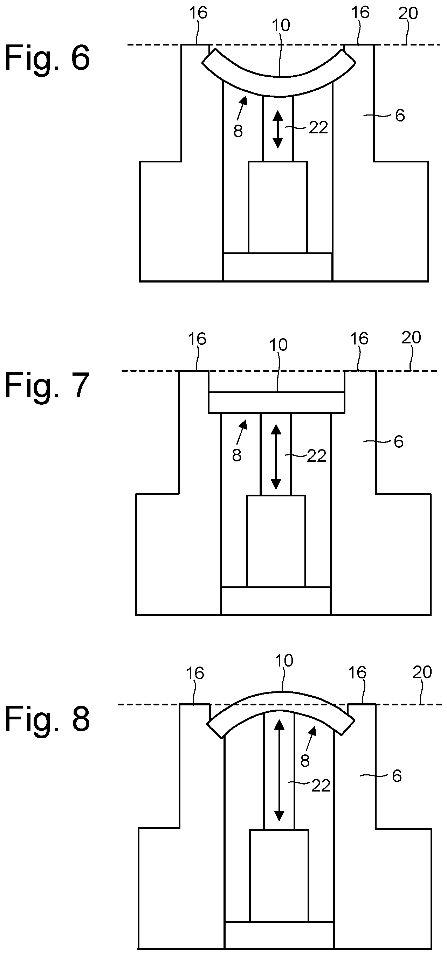

In some embodiments, the actuation system 4 is configured to deform each of one or more of the membranes 8 by driving movement of an actuation element 22 in contact with the membrane 8. Actuation can thus be mechanical rather than hydraulic or pneumatic. The actuation element 22 can be made to move using various known mechanisms, including for example a screw mechanism or a piezoelectric mechanism. The actuation element 22 does not need to remain in contact with the membrane 8 through the full range of motion of the actuation element 22. Figures 6-8 schematically depict examples of actuation of the membrane 8 formed in the burl 6 by driving movement of the actuation element 22 in contact with the membrane 8.

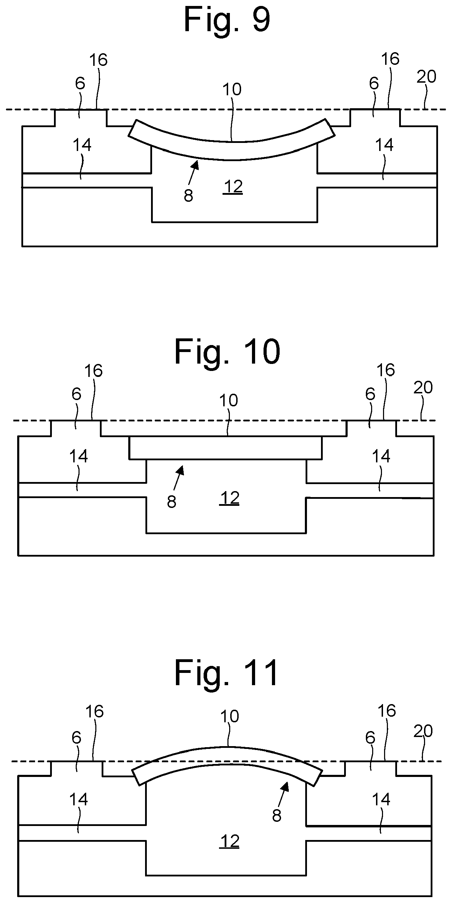

In some embodiments in which the substrate table WT comprises a plurality of rigid burls 6, each of one or more of the membranes 8 is provided in a region outside of the burls 6. Example configurations of this type are shown in Figures 9-11. Each of Figures 9-11 depicts two separate burls 6 on the right and left of the membrane 8. The burls 6 on the left and right of the membrane 8 in Figures 9-11 are typically further apart (e.g. at a pitch of around 1-3 mm) than the portions of the single burl 6 on the left and right of the membrane 8 in Figures 3-8 (which form different parts of the same burl 6 having, for example, a diameter of around 0.1-1.0 mm). The membrane 8 is provided in a region between the two separate burls 6. The membrane 8 is not therefore formed within any burl 6. Other membranes 8 may be provided that are each formed within a rigid burl 6. Viewed from above, the membrane 8 is spaced apart from the closest burls 6. The membrane 8 may be actuated using any of the hydraulic, pneumatic, or mechanical methods described above. In the embodiment shown, the membrane 8 is actuated hydraulically or pneumatically, as described above with reference to Figures 3-5. The actuation state of the membrane 8 in Figure 9 corresponds to the actuation state of the membrane 8 in Figure 3. The actuation state of the membrane 8 in Figure 10 corresponds to the actuation state of the membrane 8 in Figure 4. The actuation state of the membrane 8 in Figure 11 corresponds to the actuation state of the membrane 8 in Figure 5. Alternatively, the membrane 8 may be actuated by driving movement of an actuation element 22, as described above with reference to Figures 6-8.

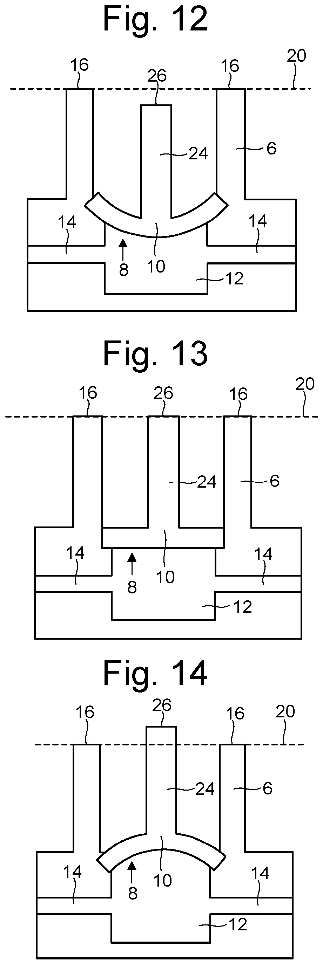

As described above, embodiments of the disclosure involve moving a contact element into and out of contact with a substrate W. In the examples described above, the contact element comprises the portion 10 of the membrane 8 whose height is changed by the deformation of the membrane 8. In embodiments of this type the membrane 8 itself may thus make direct contact with the substrate W. In other embodiments, as exemplified in Figures 12-22, the contact element comprises a rigid contacting member 24 attached to the membrane 8. The contacting member 24 does not deform when the membrane 8 deforms. The contacting member 24 may be attached integrally (without an interface) or non-integrally (with an interface) to the membrane 8. The contacting member 24 may be formed from the same material as the membrane 8 or from a different material to the membrane 8. The membrane 8 is configured so that the change in height of the portion 10 of the membrane 8 (caused by the actuation system 4) causes a change in height of the contacting member 24.

In the example of Figures 12-14, where the membrane 8 is formed within a burl 6 in a similar manner to the arrangement of Figures 3-5, the contacting member 24 may comprise a protrusion extending upwards within a cavity inside the burl 6. The contacting member 24 and the cavity may, for example, be substantially cylindrical. In the example shown, the membrane 8 is provided at substantially the same height as an uppermost surface of the substrate table WT outside of the burls 6. In other examples, the membrane 8 may be mounted at a lower or higher level within the burl 6. The level of the membrane 8 may affect the horizontal stiffness of the contacting member 24 at a distal tip 26 of the contacting member 24 (i.e. how resistant the contacting member 24 is to being displaced in the horizontal direction). In particular, it is expected that lengthening a distance between a distal tip 26 of the contacting member 24 and the membrane 8 will decrease a horizontal stiffness at the distal tip 26. Conversely, shortening the distance between the distal tip 26 of the contacting member 24 and the membrane 8 will increase a horizontal stiffness of the contacting member 24 at the distal tip 26. The horizontal stiffness may also be changed by modifying the dimensions of the membrane 8 itself. The configuration can thus be tuned to provide a desired horizontal stiffness. The membrane 8 may be actuated using any of the hydraulic, pneumatic, or mechanical methods described above. In the embodiment shown, the membrane 8 is actuated hydraulically or pneumatically, as described above with reference to Figures 3-5. The actuation state of the membrane 8 in Figure 12 corresponds to the actuation state of the membrane 8 in Figure 3. The actuation state of the membrane 8 in Figure 13 corresponds to the actuation state of the membrane 8 in Figure 4. The actuation state of the membrane 8 in Figure 14 corresponds to the actuation state of the membrane 8 in Figure 5. Alternatively, the membrane 8 may be actuated by driving movement of an actuation element 22, as described above with reference to Figures 6-8.

In an embodiment, the membrane 8 is formed from the same material as the burls 6. This approach may facilitate manufacture by allowing the substrate table WT to be formed using fewer steps. Alternatively or additionally, the approach may improve reliability by avoiding or reducing material interfaces within the burls 6. Despite being formed from the same material, the membrane 8 may be configured to be deformable while the burl 6 remains rigid by arranging for the membrane 8 to be sufficiently thin.

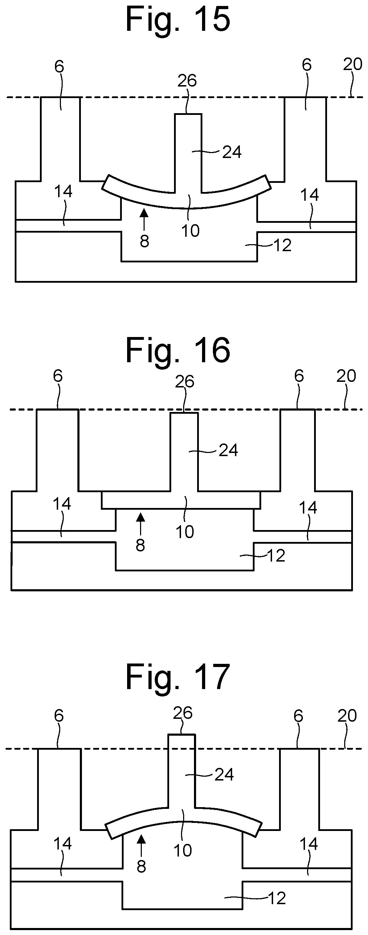

Figures 15-17 depict an example embodiment in which a contacting member 24 of the type described above with respect to Figures 12-14 is applied to an embodiment in which each of one or more of the membranes 8 is provided in a region outside of the burls 6, as described above with reference to Figures 9-11. In the embodiment shown, the membrane 8 is actuated hydraulically or pneumatically, as described above with reference to Figures 3-5. Alternatively, the membrane 8 may be actuated by driving movement of an actuation element 22, as described above with reference to Figures 6-8.

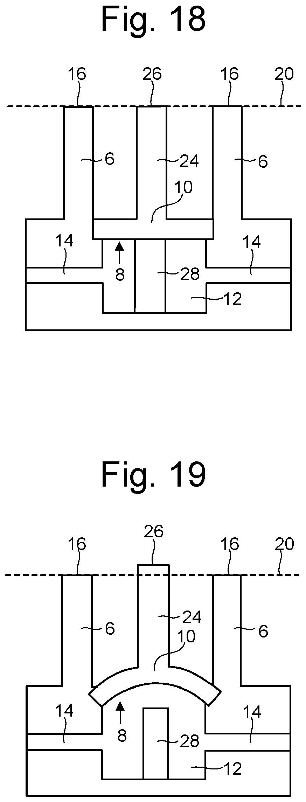

In some embodiments, as exemplified in Figures 18-22, a rigid abutment member 28 is provided beneath the membrane 8. The abutment member 28 is configured so that lowering of the portion 10 of the membrane 8 causes the contacting member 24 to become mechanically supported from below by the abutment member 28. The abutment member 28 increases the vertical stiffness of the contacting member 24 in a lowest position of the contacting member 24. In the embodiments shown, the abutment member 28 is separate to (disconnected from) the membrane 8. In other embodiments, analogous functionality is achieved by integrating at least a part of the abutment member 28 with the membrane 8 (e.g. such that the abutment member is connected to the membrane 8 and moves with the membrane 8 when the membrane 8 is deformed). Figure 18 depicts an example arrangement (with the membrane 8 unactuated) that is the same as the arrangement shown in Figure 13 except that an abutment member 28 is provided beneath the membrane 8. In this example, the abutment member 28 increases resistance against the membrane 8 deflecting downwards when force is applied to the contacting member 24 from above (e.g. from the substrate W). When the distal tip 26 of the contacting member 24 is in the same plane 20 as the distal tip 16 of the burl 6 when the membrane 8 contacts the abutment member 28, the contacting member 24 and the burl 6 may simultaneously contact the substrate W. This configuration may allow a high friction contact to be made with the substrate W after the substrate W is clamped after loading (e.g. during exposure of the substrate W during alignment or in a lithography process). As depicted in Figure 19, however, the configuration still allows distal tip 26 of the contacting member 24 to be moved above the plane 20 to provide a different interaction with the substrate W (e.g. a lower friction contact or an intermittent contact) by deforming the membrane 8 upwards (hydraulically, pneumatically, or mechanically).

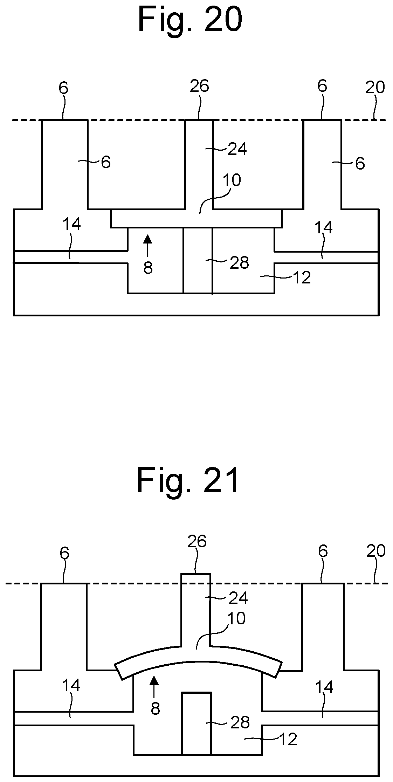

Figures 20 and 21 depict an example embodiment in which the abutment member 28 of the type described above with respect to Figures 18 and 19 is applied to an embodiment in which each of one or more of the membranes 8 is provided in a region outside of the burls 6, as described above with reference to Figures 9-11.

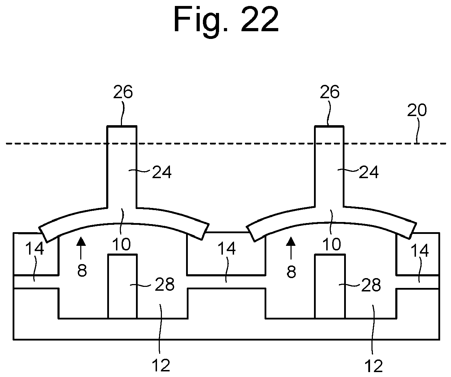

In the embodiments described above, the substrate WT is configured to allow contact with the substrate W at different times by both rigid burls 6 (which do not move) and contact elements that are moveable by deformation of respective membranes 8. In other embodiments, as exemplified in Figure 22, the substrate table WT may be configured to provide contact with the substrate W exclusively via contact elements that are moveable by deformation of respective membranes 8. In the example shown, plural membranes 8 are provided. Each membrane 8 comprises a contacting member 24 extending upwards from the membrane 8. Deformation of each membrane 8 may be achieved using any of the techniques described above. Deformation of the membrane 8 upwards raises the distal tip 26 of the contacting element 24 above the plane 20 and may be used for example to reduce friction-induced stresses in the substrate W during loading of the substrate W (e.g. by providing a dithered contact as described below). When the membrane 8 is unactuated, the membrane 8 is supported from below by the abutment member 28. The combination of contacting member 24 and abutment member 28 provides stiffness in the vertical direction comparable to a rigid burl 6, thereby allowing the substrate W to be clamped to the substrate table WT (against the contacting members 24) as firmly as if the substrate W were held against rigid burls 6.

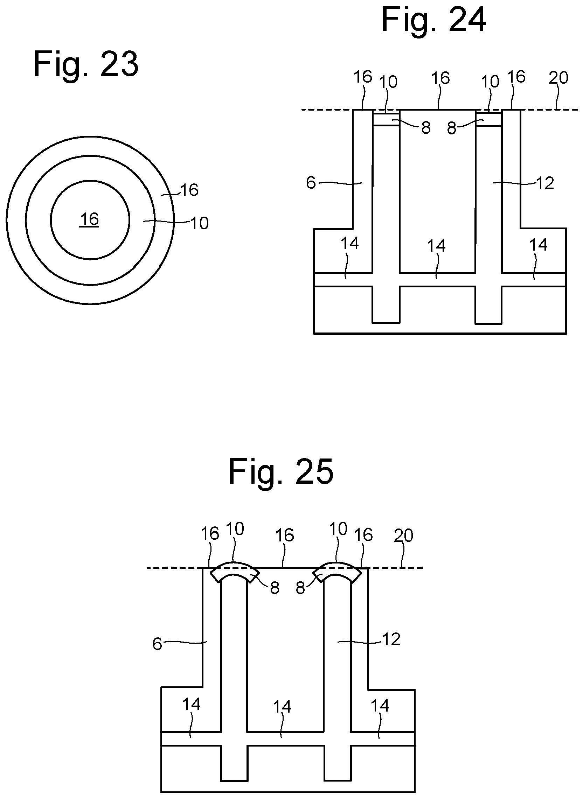

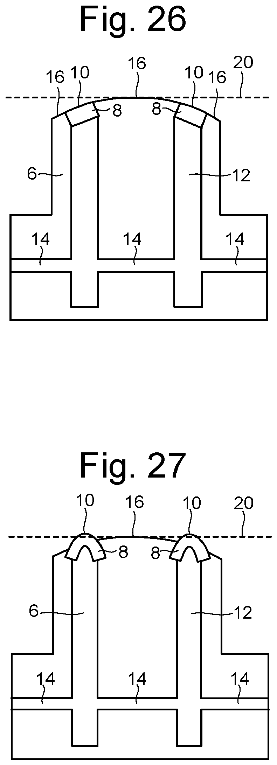

In some embodiments, as exemplified in Figures 23-25, each of one or more of the membranes 8 has a shape when viewed from above that forms a hollow closed loop (rather than being a closed, non-hollow shape, as in the embodiments described above). As seen in Figure 23, in the example shown the hollow closed loop is a circular annulus, but other forms may be used. In the example shown, the membrane 8 is formed within the burl 6. Figure 24 depicts the membrane 8 in an undistorted state where the membrane 8 is undeformed. An uppermost portion 10 of the membrane 8 is lower than the distal tip 16 of the burl 6. The membrane 8 does not contact the substrate W in this state. Figure 25 depicts the membrane 8 in an actuated state. An uppermost portion 10 of the membrane protrudes above the distal tip 16 of the burl 6 and can therefore contact the substrate W in this state. Figures 26 and 27 depict a variation on the arrangement of Figures 23-25 in which an upper surface of the burl 6 has a rounded form, thereby provided a more spatially localised distal tip 16. In a further variation (not shown), the burl 6 may have slanted side walls so that the width of the burl 6 is wider at the bottom than at the top. Slanted side walls may increase a strength of the burl 6. In a further variation, a central portion of the burl 6 (inside the hollow closed loop of the membrane 8) is arranged to be moveable in the vertical direction. The movement of the central portion of the burl 6 can be driven by deformation of the membrane 8 acting for example in a similar manner to a leaf spring. The central portion of the burl 6 in this embodiment is a further example of a rigid contacting member that is attached to the membrane 8. The change in height of the portion of the membrane 8 caused by deformation of the membrane 8 causes a change in height of the central portion of the burl 6 (acting as rigid contacting member).

The actuation system 4 may be configured to deform all of the membranes 8 at the same time and in the same way. This may be appropriate, for example, when it is desired to bring all of the contact elements associated with the membranes 8 into contact with, or out of contact with, the substrate W at the same time.

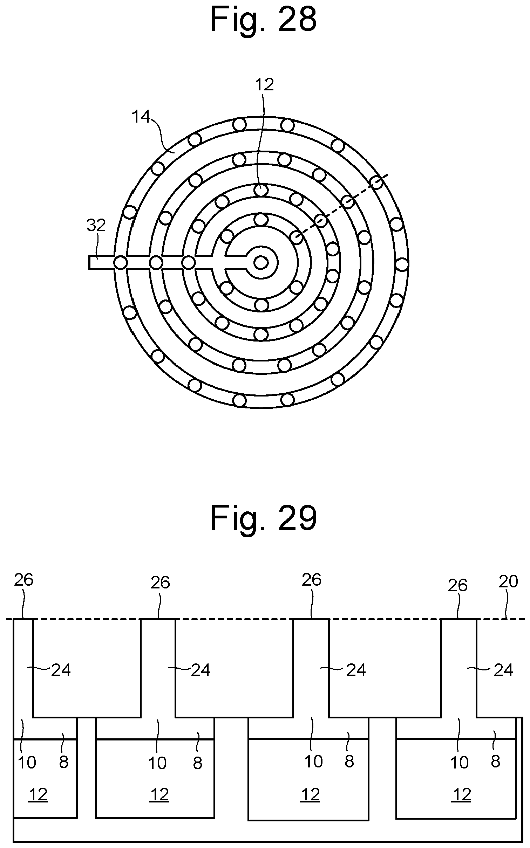

Figures 28 and 29 depict an example embodiment, in the case where actuation of the membranes 8 is performed hydraulically or pneumatically. In this embodiment, a network of fluid distribution channels 14 is arranged in four concentric circles. Each of the chambers 12 that actuate one of the membranes 8 is positioned above one of the four concentric circles. Each membrane 8 is connected to a contacting member 24 that is moveable upwards and downwards by actuation of the membrane 8. A coupling channel 32 connects the network to a pressure controller (e.g. pump). Pressures in the chambers 12 can be simultaneously set to a desired value by setting an appropriate pressure in the coupling channel 32. For example, when it is desired to deform the membranes 8 upwards, the pressure in the coupling channel 32 is increased. When it is desired to lower the membranes 8, the pressure in the coupling channel 32 is lowered.

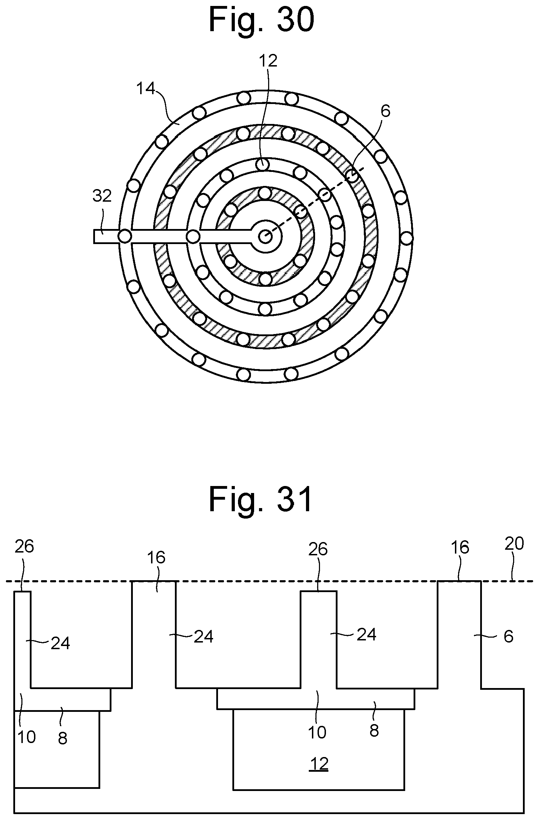

Figures 30 and 31 depicts a further example in which a combination of rigid burls 6 and moveable contacting members 24 can contact the substrate W. A network of fluid distribution channels 14 is arranged in two concentric circles (non-hatched). Each of the chambers 12 that actuate one of the membranes 8 is positioned above one of the two concentric circles. Each membrane 8 is connected to a contacting member 24 that is moveable upwards and downwards by actuation of the membrane 8. A coupling channel 32 connects the network to a pressure controller (e.g. pump) and vertical movement of the contacting members 24 can be controlled as described above for the arrangement of Figures 28 and 29. The rigid burls 6 are positioned above different concentric circles (hatched) that are interleaved between the concentric circles of the network of fluid distribution channels 14.

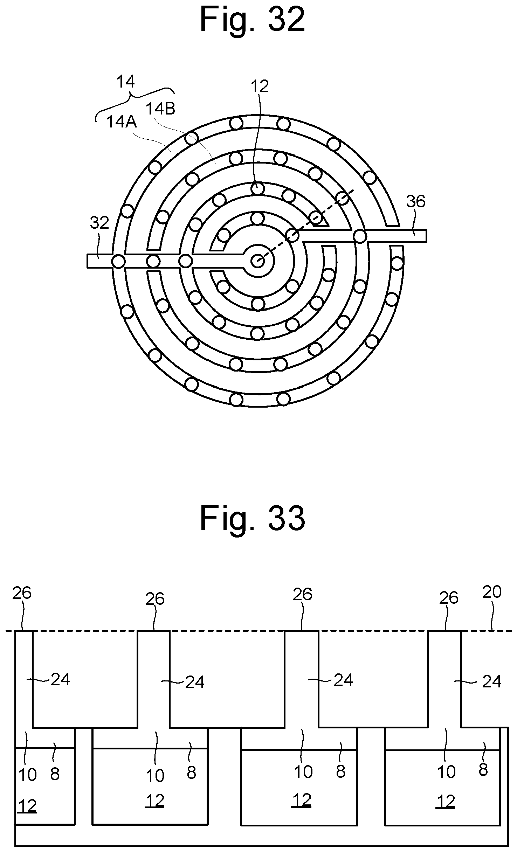

In some embodiments, the actuation system 4 is configured to deform each of a set of one or more of the membranes 8 independently of one or more of the other membranes 8. This configuration provides flexibility for more complex modes of interaction between the substrate table WT and the substrate W. Figures 32 and 33 depict an example embodiment. The arrangement depicted is similar to the arrangement of Figures 28 and 29 in that a network of fluid distribution channels 14 is arranged in four concentric circles, with each of the chambers 12 that actuate one of the membranes 8 being positioned above one of the four concentric circles. Each membrane 8 is also connected to a contacting member 24 that is moveable upwards and downwards by actuation of the membrane 8. However, in contrast to the arrangement of Figures 28 and 29, the network of fluid distribution channels 14 comprises a plurality of fluidically isolated sub-networks 14A-14B. The isolation of each sub-network 14A-14B allows the pressure in each the sub-network 14A-14B to be set independently of the pressure in each of the other sub-networks 14B-14A. In the example shown, two sub-networks 14A-14B are provided but it will be understood that more sub-networks could be provided if desired. In the example shown, a first sub-network 14A is connected to a pressure controller (e.g. pump) via a coupling channel 32. A second sub-network 14B is connected to a further pressure controller (e.g. pump) via a further coupling channel 36. In the example shown, the network of fluid distribution channels 14 comprises four concentric circles, with adjacent concentric circles belonging to different sub-networks 14A-14B. By independent control of the pressures in the coupling channel 32 and the further coupling channel 36 it is possible to independently control the pressures in adjacent concentric circles. Membranes 8 in adjacent concentric circles can thus be actuated independently of each other.

In some embodiments, each of one or more of the membranes 8 is formed from a single integral material. In such embodiments, an upper surface of the membrane 8 has the same composition as a lower surface of the membrane 8. In such embodiments, the membrane 8 may, for example, be formed from the same material as surrounding portions of the substrate table WT. In cases where the membrane 8 is formed within the burl 6, for example, the membrane 8 may be formed from the same material as the burl 6. In other embodiments, the membrane 8 is formed from a different material to the surrounding portions of the substrate table WT.

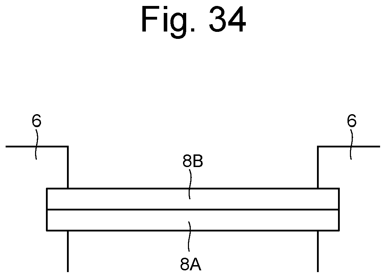

In some embodiments, each of one or more of the membranes 8 comprises plural layers. Figure 34 depicts an example of such an embodiment in which the membrane 8 comprises two layers 8A-8B. Two or more of the layers have different compositions relative to each other. Providing plural layers having different compositions provides improved flexibility for tuning overall properties of the membrane 8. For example, in an embodiment, a material of an uppermost layer 8B is arranged to have a lower stiffness than a material of at least one layer 8A below the uppermost layer 8B. The uppermost layer 8B may, for example, be formed from a low stiffness polymer. Thus, a layer of the membrane 8 that contacts the substrate W directly (the uppermost layer 8B) may be made to have low stiffness without compromising the overall ability of the membrane 8 to be deformed in a reliable and repeatable manner, which can be ensured by providing lower layers 8A that are designed specifically for that purpose. The lower stiffness of the uppermost layer 8B allows the membrane 8 to yield horizontally more easily, thereby helping to reduce friction-induced stresses in the substrate W during loading of the substrate W. An increase in a contact area between the substrate W and the substrate table WT caused by the lower stiffness of the uppermost layer 8B may increase the chance of particulate contaminants being trapped between the burls 6 and the substrate W after loading. The low stiffness of the uppermost layer 8B reduces the negative impact of such contaminants because the contaminants can partially or completely sink into the uppermost layer 8B.

The embodiments described provide a range of possibilities for how contact between the substrate W and substrate WT can be controlled at various stages in the manipulation of a substrate W for lithography. Methods of handling a substrate using a substrate table WT according to any of the embodiments described above may be applied for example to a stage where the substrate W is being loaded onto a substrate W, including a period of time shortly before a first contact is made between the substrate W and the substrate table WT, a period of time shortly after the first contact, a period of time where the substrate W is firmly clamped to the substrate WT (e.g. during exposure in an alignment process and/or a lithography process), a period of time just before unloading of the substrate W from the substrate table WT, and a period of time during unloading of the substrate W from the substrate table WT.

In an embodiment, a method is provided in which a substrate W is loaded onto a substrate table WT comprising one or more membranes 8. The substrate table WT may be configured in any of the ways described above with reference to Figures 2-34. The method comprises deforming each of one or more of the membranes 8 to change a height of a portion 10 of the membrane 8 during or after the loading of the substrate W.

In an embodiment, the deformation of the membranes 8 causes multiple cycles of making and breaking of contact between the substrate W and the substrate table WT. The multiple cycles may be performed rapidly (e.g. multiple times a second, desirably at 10 Hz or more). Application of the multiple cycles may be referred to as dithering. During the dithering, the contact between the substrate W and the substrate WT may be made and broken exclusively between the substrate W and contact elements driven to move vertically by the deformation of the membranes 8 (e.g. the membranes 8 themselves or contacting members 24 attached to the membranes 8). In other embodiments, as described below, contact with the substrate W may be switched between contact via contact elements and contact via rigid burls 6. When applied during loading of the substrate W, the dithering reduces friction between the substrate W and the substrate table WT, thereby reducing friction-induced stresses in the substrate W. When applied after loading of the substrate W, the dithering can allow any residual friction-induced stresses in the substrate W to partially or completely relax.

In an embodiment, a method is provided in which the deformation of the membranes 8 causes a contact between the substrate W and the substrate table WT to switch repeatedly between contact via a first set of contact points and contact via a second set of contact points. The repeated switching may be performed during loading of the substrate W onto the substrate table WT. Alternatively or additionally, the repeated switching may be performed after loading of the substrate W onto the substrate table WT. In some embodiments, all or a majority of the first set of contact points are contacts between the substrate W and rigid burls 6 of the substrate table WT. In some embodiments, all or a majority of the second set of contact points are contacts between the substrate W and contact elements driven to move vertically by the deformation of the membranes 8. As described above, each of the contact elements may comprise a portion 10 of a respective membrane 8 or a distal tip 26 of a contacting member 24. In an embodiment, an overall horizontal stiffness of the contact elements is arranged to be lower (e.g. at least ten times lower) than an overall horizontal stiffness of the burls 6. In this way, each time the substrate W is transferred from the burls 6 to the contact elements, friction-induced stresses with the substrate W relax by a factor commensurate with a difference in the overall horizontal stiffnesses. This approach may be particularly effective where the contact elements are provided by contacting members 24 attached to the membranes 8 because the contacting members 24 may achieve lower horizontal stiffness at the distal tips 26 of the contacting members 24 than is possible at any point in the membranes 8. Additionally, the contacting members 24 may also reduce friction with the substrate W by making contact with the substrate W over a smaller area than would be possible if the membranes 8 made contact directly with the substrate W. These methods may be implemented using any of the embodiments described above that comprise rigid burls 6 (e.g. as described with reference to any of Figures 2-21, 23-27, 30 and 31).

In some embodiments, the loading of the substrate W comprises loading the substrate W onto contact elements configured to move vertically by deformation of the membranes 8 and the method comprises deforming the membranes 8 after loading of the substrate W so that the substrate W is lowered onto rigid burls 6 of the substrate table WT. Friction between the contact elements and the substrate W is desirably made to be lower (e.g. by configuring the contact elements to be relatively rough and/or soft and/or to have anti-adhesive coatings) than friction between the rigid burls 6 and the substrate W. Thus, a relatively low friction first contact can be made between the substrate W and the substrate table WT (via the contact elements) with a higher friction second contact being made between the substrate W and the substrate table WT at a later time (via the rigid burls 6). The low friction first contact reduces friction-induced stresses in the substrate W by allowing a greater degree of slippage between the substrate W and the contact elements than would have been allowed had the first contact been made exclusively between the substrate W and the rigid burls 6. The subsequent transfer of contact to the rigid burls 6 allows frictional forces between the substrate W and substrate table WT to be increased at later time. The rigid burls 6 may, for example, be optimized in this embodiment for high friction. Increased friction is desirable for example when the substrate W is clamped to the substrate table WT during exposure. The rigid burls 6 may also be optimized for high wear resistance, thereby increasing a lifetime of the substrate table WT. The method may be implemented using any of the embodiments described above that comprise rigid burls 6 (e.g. as described with reference to any of Figures 2-21, 23-27, 30 and 31).

In some embodiments, the loading of the substrate W comprises loading the substrate W onto rigid burls 6 of the substrate table WT and the method comprises deforming the membranes 8 after loading of the substrate W so that contact elements driven to move vertically by deformation of the membranes 8 lift the substrate W above the rigid burls 6. Friction between the rigid burls 6 and the substrate W is desirably made lower than friction between the contact elements and the substrate W. Thus, a relatively low friction contact can be made between the substrate W and the substrate table WT (via the rigid burls 6) with a higher friction second contact being made between the substrate W and the substrate table WT at a later time (via the contact elements). The low friction first contact reduces friction-induced stresses in the substrate W by allowing a greater degree of slippage between the substrate W and the rigid burls 6 than would have been allowed had the first contact been made exclusively between the substrate W and the contact elements. The subsequent transfer of contact to the contact elements allows frictional forces between the substrate W and substrate table WT to be increased at a later time. Increased friction is desirable for example when the substrate W is clamped to the substrate table WT during processing in a lithography process. The higher friction may be achieved by configuring the contact elements to have a high coefficient of friction and/or by configuring the contact elements to provide a larger surface area in contact with the substrate WT than is achieved when the substrate W is in contact exclusively with the burls 6. The method may be implemented using any of the embodiments described above that comprise rigid burls 6 (e.g. as described with reference to any of Figures 2-21, 23-27, 30 and 31).

In some embodiments, deformation of the membranes 8 is used to improve unloading of the substrate W from the substrate table WT. For example, in some embodiments the membranes 8 are deformed so that a final contact between the substrate W and the substrate table WT during the unloading occurs via contact elements configured to move vertically by deformation of the membranes 8, and the contact elements have higher wear resistance than rigid burls 6 of the substrate table WT. Elements of the substrate table WT that are in contact with the substrate W at the point when the substrate W leaves the substrate table WT during unloading are particularly vulnerable to wear. Wear may undesirably impact focus and/or overlay performance. Increasing the wear resistance of these elements increases the lifetime of the substrate table WT and reduces negative impact on focus and/or overlay. Increasing the wear resistance by transferring contact between the substrate W and the substrate table WT from rigid burls 6 to the contact elements reduces wear on the rigid burls 6 as well as increasing flexibility for selecting the composition of the rigid burls 6. It is less necessary, for example, to configure the rigid burls 6 to have high wear resistance. The rigid burls 6 can be optimized for other properties, such as ease of manufacture and/or high friction.

Similar considerations apply during loading of the substrate W. Accordingly, embodiments may be provided in which membranes 8 are deformed so that a first contact between the substrate W and the substrate table WT during the loading occurs via contact elements configured to move vertically by deformation of the membranes 8, and the contact elements have higher wear resistance than burls of the substrate table.

Alternatively or additionally, in some embodiments the membranes 8 are deformed so that a final contact between the substrate W and the substrate table WT during the unloading occurs via rigid burls 6 on the substrate table WT, and the rigid burls 6 have a higher wear resistance than contact elements configured to move vertically by deformation of the membranes 8. The ability to transfer the substrate W between the rigid burls 6 and the contact elements increases freedom for configuring the rigid burls 6 to have high wear resistance. Compromises in properties of the rigid burls 6 arising from the high wear resistance, such as low coefficient of friction, can be mitigated using the contact elements (e.g. by arranging for the substrate W to be completely or partially supported by contact elements configured to provide higher friction during clamping of the substrate W during exposure).

Similar considerations apply during loading of the substrate W. Accordingly, embodiments may be provided in which membranes 8 are deformed so that a first contact between the substrate W and the substrate table WT during the loading occurs via rigid burls 6 of the substrate table WT, and the rigid burls 6 have higher wear resistance than contact elements configured to move vertically by deformation of the membranes 8.

In some embodiments, the deformation of the membranes 8 is used to improve clamping effectiveness. In an embodiment, a method is provided that comprises clamping the substrate W onto the substrate table WT and exposing the substrate W to radiation while the substrate W is clamped to the substrate table WT. The irradiation may be performed during a substrate alignment procedure and/or during exposure in a lithography process, for example. In an embodiment, a clamping force is increased by deforming one or more of the membranes 8 downwards while the substrate W is clamped to the substrate table WT. Alternatively or additionally, in an embodiment, a frictional force between the substrate W and the substrate table WT is increased by deforming each of one or more of the membranes 8 to press a respective contact element against the substrate W while the substrate W is clamped to the substrate table WT.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains one or multiple processed layers.

Although specific reference may have been made above to the use of embodiments of the invention in the context of optical lithography, it will be appreciated that the invention may be used in other applications.

While specific embodiments of the invention have been described above, it will be appreciated that the invention may be practiced otherwise than as described.

The descriptions above are intended to be illustrative, not limiting. Thus, it will be apparent to one skilled in the art that modifications may be made to the invention as described without departing from the scope of the claims set out below.

## Claims

1. A substrate table configured to support a substrate during a lithography process, comprising:
one or more membranes; and
an actuation system configured to deform each membrane to change a height of a portion of the membrane.

2. The substrate table of claim 1, wherein each membrane is configured such that, when the substrate is supported by the substrate table, the changing of height of the portion of the membrane causes a change in a spatial distribution of forces applied between the substrate table and the substrate.

3. The substrate table of claim 1 or 2, wherein each membrane is configured such that, when the substrate is supported by the substrate table, the changing of height of the portion of the membrane causes:
a contact element to move from a position out of contact with the substrate to a position in contact with the substrate; or
a contact element to move from a position in contact with the substrate to a position out of contact with the substrate.

4. The substrate table of claim 3, wherein the contact element comprises the portion of the membrane.

5. The substrate table of claim 3, wherein the contact element comprises a rigid contacting member attached to the membrane and the membrane is configured so that the change in height of the portion of the membrane causes a change in height of the contacting member.

6. The substrate table of claim 5, wherein a rigid abutment member is provided beneath the membrane, the abutment member being configured so that lowering of the portion of the membrane causes the contacting member to become mechanically supported from below by the abutment member.

7. The substrate table of any preceding claim, wherein:
the substrate table comprises a plurality of rigid burls configured to contact the substrate; and
each of one or more of the membranes is formed within a respective one of the burls.

8. The substrate table of any preceding claim, wherein:
the substrate table comprises a plurality of rigid burls configured to contact the substrate; and
each of one or more of the membranes is formed in a region outside of the burls.

9. The substrate table of claim 7 or 8, wherein the membranes are formed from the same material as the rigid burls.

10. The substrate table of any preceding claim, wherein each of one or more of the membranes has a shape when viewed from above that forms a hollow closed loop.

11. The substrate table of any preceding claim, wherein each of one or more of the membranes comprises plural layers and a material of an uppermost layer has a lower stiffness than a material of at least one layer below the uppermost layer.

12. The substrate table of any preceding claim, wherein the actuation system is configured to deform each of one or more of the membranes by changing a pressure of a fluid in contact with the membrane.

13. The substrate table of any preceding claim, wherein the actuation system is configured to deform each of one or more of the membranes by driving movement of an actuation element in contact with the membrane.

14. The substrate table of any preceding claim, wherein the actuation system is configured to deform each of a set of one or more of the membranes independently of one or more of the other membranes.

15. The substrate table of any preceding claim, wherein the actuation system is configured to clamp a substrate to the substrate table, the clamping of the substrate causing the deformation of each membrane by pressing of the substrate against the membrane.

16. A substrate table configured to support a substrate during a lithography process, comprising:
one or more membranes, each membrane being deformable to change a height of a portion of the membrane; and
a clamping system for clamping a substrate to the substrate table, wherein the clamping deforms each membrane by pressing the substrate against the membrane.

17. The substrate table of any preceding claim, wherein:
the substrate table comprises a plurality of rigid burls configured to contact the substrate; and
a portion of each membrane is higher than the rigid burls when the membrane is in an undeformed state.

18. A method of handling a substrate, comprising loading a substrate onto the substrate table of any preceding claim.

19. A method of handling a substrate, comprising:
loading the substrate onto a substrate table comprising one or more membranes; and
deforming each of one or more of the membranes to change a height of a portion of the membrane during or after the loading of the substrate.

20. The method of claim 18 or 19, wherein the deformation of the membranes causes multiple cycles of making and breaking of contact between the substrate and the substrate table during or after the loading of the substrate.

21. The method of any of claims 18-20, wherein the deformation of the membranes causes a contact between the substrate and the substrate table to switch repeatedly between contact via a first set of contact points and contact via a second set of contact points.

22. The method of claim 21, wherein the repeated switching is performed during loading of the substrate onto the substrate table.

23. The method of claim 21 or 22, wherein the repeated switching is performed after loading of the substrate onto the substrate table.

24. The method of any of claims 21-23, wherein:
all or a majority of the first set of contact points are contacts between the substrate and rigid burls of the substrate table; and
all or a majority of the second set of contact points are contacts between the substrate and contact elements driven to move vertically by the deformation of the membranes.

25. The method of claim 24, wherein an average horizontal stiffness of the contact elements is lower than an average horizontal stiffness of the rigid burls.

26. The method of claim 18 or 19, wherein:
the loading of the substrate comprises loading the substrate onto contact elements configured to move vertically by deformation of the membranes; and
the method comprises deforming the membranes after loading of the substrate so that the substrate is lowered onto rigid burls of the substrate table.

27. The method of claim 26, wherein friction between the contact elements and the substrate is lower than friction between the burls and the substrate.

28. The method of claim 18 or 19, wherein:
the loading of the substrate comprises loading the substrate onto rigid burls of the substrate table; and
the method comprises deforming the membranes after loading of the substrate so that contact elements driven to move vertically by deformation of the membranes lift the substrate above the rigid burls.

29. The method of claim 28, wherein friction between the burls and the substrate is lower than friction between the contact elements and the substrate.

30. The method of any of claims 18-29, further comprising unloading the substrate from the substrate table, wherein the membranes are deformed so that:
a final contact between the substrate and the substrate table during the unloading occurs via contact elements configured to move vertically by deformation of the membranes, and the contact elements have higher wear resistance than rigid burls of the substrate table; or
a final contact between the substrate and the substrate table during the unloading occurs via rigid burls on the substrate table, and the burls have a higher wear resistance than contact elements configured to move vertically by deformation of the membranes.

31. The method of any of claims 18-30, further comprising loading the substrate onto the substrate table, wherein the membranes are deformed so that:
a first contact between the substrate and the substrate table during the loading occurs via contact elements configured to move vertically by deformation of the membranes, and the contact elements have higher wear resistance than burls of the substrate table; or
a first contact between the substrate and the substrate table during the loading occurs via rigid burls of the substrate table, and the burls have higher wear resistance than contact elements configured to move vertically by deformation of the membranes.

32. The method of any of claims 18-31, further comprising:
clamping the substrate onto the substrate table and exposing the substrate to radiation while the substrate is clamped to the substrate table; and one or both of the following:
increasing a clamping force by deforming one or more of the membranes downwards while the substrate is clamped to the substrate table; and
increasing friction between the substrate and the substrate table by deforming each of one or more of the membranes to press a respective contact element against the substrate while the substrate is clamped to the substrate table.

33. The method of any of claims 24-32, wherein:
each of one or more of the contact elements comprises a portion of the membrane that is changed in height by deformation of a respective one of the membranes; and/or
each of one or more of the contact elements comprises a rigid contacting member that is changed in height by deformation of a respective one of the membranes.
